# EUROPEAN PATENT SPECIFICATION

(11) **EP 3 112 884 B1**
(45) Date of publication and mention of the grant of the patent: **30.08.2023**
(21) Application number: 15174648.4
(22) Date of filing: 30.06.2015
(51) Int. Cl.: G01R 19/25

(54) **PARAMETERIZABLE MERGING UNIT FOR SENSOR-BASED MEASUREMENT, AND METHOD TO OPERATE SUCH UNIT**
PARAMETRISIERBARE ZUSAMMENFÜHRUNGSEINHEIT FÜR SENSORBASIERTE MESSUNG UND VERFAHREN ZUM BETRIEB SOLCH EINER EINHEIT
UNITÉ DE FUSION PARAMÉTRABLE POUR MESURE PAR CAPTEUR ET PROCÉDÉ POUR FAIRE FONCTIONNER UNE TELLE UNITÉ

(43) Date of publication of application: 04.01.2017
(73) Proprietor: ABB s.r.o., 14000 Prague (CZ); Brno University Of Technology, 60190 Brno (CZ)
(72) Inventor: Havranek, Zdenek, 59501 Velká Bítes (CZ); Klusacek, Stanislav, 638 00 Brno (CZ); Drapela, Jiri, 621 00 Brno (CZ); Sevcik, Bretislav, 628 00 Brno (CZ)
(74) Representative: Maiwald GmbH

(56) References cited:
- EP-A1- 1 936 391
- WO-A1-2010/068582
- WO-A1-2014/044408
- US-A1- 2004 027 750

## Description

The invention relates to a parameterizable merging unit for sensor-based measurement of current and voltage in high voltage networks or electrical grids operating with other voltage levels, and a method to operate such a unit, according to claims 1 and 11.

### State of the Art

At present, the measurement of voltages and currents in high voltage power grids still exploits principles (such as iron core current transformer) which, despite ensuring high accuracy within the nominal range and at the working frequency, exhibit significantly worsened metrological parameters in measurement at high frequencies or for higher dynamics signals exceeding the basic measuring range of the sensor; the reason behind the described situation generally lies in the conservative approach of both energy distributors and individualend users. Current power distribution grids, however, do not transfer only energy signals at the basic frequency: the power consumption of advanced devices, in which electronic converters have been replaced by mains transformers, comprises also a substantial portion of signals containing higher harmonic components of the nominal grid frequency and, in some cases, signals with frequencies of up to tens or (exceptionally) hundreds of kHz.

For these measurement areas, current sensors based on Rogowski coil were developed, utilizing the coil as a sensing element which, thanks to the non-ferromagnetic (air) core, provides a multiply higher dynamical and a far wider frequency range of measured currents (even within units of MHz in special cases) compared to classical designs. The principal drawback of such sensing systems consists in that the output electrical signal (electrical voltage) is not directly proportional to the flowing primary current but only to its derivation; furthermore, these sensors are designed in such a manner that the output voltage level at nominal primary current ranges between tens of millivolts to units of volts. Similar output voltage ranges are also found in other commonly used current sensors, where, for example, electronic transformers or Hall probes are applied. Such solution requires substantially better shielding of output cables from the sensor, and these demands as a whole are usually difficult to satisfy in industrial conditions. The magnitude of the output voltage is given by the design of the sensor and, especially in sensors based on Rogowski coil, by the cross section of the winding and the number of turns; thus, the magnitude cannot be increased excessively. This may result in a growth of the internal resistance, self-inductance of the winding, and interturn capacity, all of which reduce the accuracy and affects the frequency characteristics of the sensor. Even though the nonferrous core of a sensor ensures a broad dynamical and frequency range of the measured currents, the sensitivity of the Rogowski coil depends significantly on the temperature if the core is made of common materials. Other spurious factors include location of the primary current conductor off the Rogowski coil axis, ageing of the material used for the core, and ageing of the applied sealant. The transfer of the electrical signal from the sensor and the total achievable measurement accuracy are also affected by variable input impedance of the connected postprocessing device because, considering the common Rogowski coil design, the internal electrical impedance of the coil is within the order of hundreds of Ohms to units of kiloohms (or even higher in exceptional cases); thus, we have to take into account the voltage drop on this impedance. It clearly follows from this description that the variable input impedance of the related circuit causes a major source of possible measurement error.

In evaluating the output signal of a Rogowski coil as the current sensor, it is necessary to use an analog or digital integrator to create, from the measured primary current derivation, an electrical signal or digital information directly corresponding to the instantaneous value of primary current. In this case, the output signal frequency as a substantial parameterdetermines the conversion coefficient for the integration.

Recent voltage sensors utilize impedance dividers based on capacitive or resistive elements, with major emphasis on minimizing the influence of the surrounding environment therein. However, although such effect can be markedly reduced, it cannot be completely eliminated during postprocessing; furthermore, in cases where very high measurement accuracy is required, it would be necessary (similarly as in current sensors) to know the dependencies of the output signals on the most significant spurious effects and, ideally, to monitor the operating conditions of the sensor. In this context, attention should be paid also to the actual wiring of the output electrical signal and to the input electrical parameters of the applied data acquisition circuitry for these sensors with respect to their high output impedance.

The above-outlined definition of present-day principles and structural alternatives of voltage and current sensors yields the requirement for the widest possible substitution of the low-voltage output signal transmitted at a higher impedance; which is typical of such sensors, by digital signal. Other requirements express the need of supplementary information on theactual measurement conditions and availability of the data related to the sensor parameters and conditions obtained from or characterizing the design and (mainly) routine tests during operation of the device. This set of information is to facilitate all and any corrections and adjustment at a later time.

Measurement based on the digitization of output signals from voltage and current sensors in high voltage grids and possible correction of major spurious effects may provide results more accurate than those obtained with classic instrument transformers, and the generally simple and lightweight structure of the digital technology will reduce the energy consumption and minimize the impact on the human environment. The present-day transfer of output analog signals from classic sensors is, however, possible only at short distances; this is due to the low output power and the related higher vulnerability of such transmission systems to ambient disturbances, which are an omnipresent aspect of industrial conditions. For the given reasons, advanced sensing technologies remain outside the main field of interest of power engineering specialists.

Examples of that state of the art are disclosed in US 2004/027750 A1, WO 2010/068582 A1, EP 1 936 391 A1, and WO 2014/044408 A1.

### Object of the invention

So the object of the invention is, to enhance the electronical unit and the method to operate the same, in such, to result in a higher vulnerability of such systems to ambient disturbancy in an easy and constructively compact way, and to improve the measurement accuracy with that.

According to a parameterizable merging unit for sensor-based measurement of current and voltage in high voltage networks or electrical grids, the problem is solved by the features of claim 1.

Further advantageous embodiments of such a unit are given by depending claims 2 to 10,

According to a method to operate a parameterizable merging unit, the problem is solved by the features of claim 11.

Further advantageous embodiments to that are given by further claims.

The given unit processes analog or digital signals from current and voltage sensors based on, for example, impedance dividers and Rogowski coils; the digitized data (the instantaneous values of measured currents and voltages) are made accessible at the process bus and subsequently utilized within electronic protection devices or in systems measuring the quality of electrical energy. The proposed technical solution facilitates the processing of measured information, which can be further transferred at longer distances (>10 m) without being influenced by the surrounding environment. The described systems are to find application in present-day substations and smart grids; these target areas ought to support advanced regulation of energy supply and consumption, exhibiting a high degree of grid autonomy.

According to the method of operating such a unit, the method for operating a parameterizable merging unit according to one of the claims 1 to 13, works like that, that the analog signal from the sensor device are sent to a separated analog input of the parameterizable merging unit, which is galvanically isolated from the digital processing unit, which receives data from the analog input module.

In a further advantageous embodiment, the correction data are stored in a correction data memory, which is physically implemented into the merging unit, and that the calibration data are physically implemented into the current/voltage sensor, and that both data are interlinked via a ditigal link.

### Summary of the invention

The technical solution consists in a merging unit for sensor-based measurement of current and voltage, which improves the measurement accuracy by minimizing the spurious effects that affect predominantly the sensing elements of individual sensors. Further, the discussed technical solution exploits the additional information obtained during the design and single tests of the sensors, thus facilitating effective correction of the measured instantaneous values of current and voltage; such correction considers the design and manufacturing-related differences between the sensors and the existing operational conditions. Even more, the given technical solution ensures sufficient variability of methods applied to enable the connection of various types of current and voltage sensors with low-voltage, high-impedance output signal. In the described case, *low-voltage, high-impedance signal* denotes the output signal of a voltage source exhibiting an internal impedance within the order of hundreds of Ohms to units of kiloohms and a magnitude of the output voltage amplitude ranging between tens of millivolts and units of volts.

The merging unit 1 comprises input channels 3 for the processing of analog or digital signals from the connected sensors 2, and a digital section 4 consisting of a field-programmable gate array 5, a microcontroller 6, and clock circuitry 8 for timing the digital processing and synchronization. The merging unit 1 is both hardware-configurable and software-parameterizable. In the hardware area, the unit is configurable with respect to the type and mode of connection of the sensors 2, which are always defined together with the maximum achievable measurement accuracy and the field of application of a concrete sensing element. With respect to the required measurement accuracy, practical applicability, and immunity to interferences affecting the transfer path of the measured signal, it is possible to select one of the four available methods enabling transmission of the measured data and connection of the applied sensor.

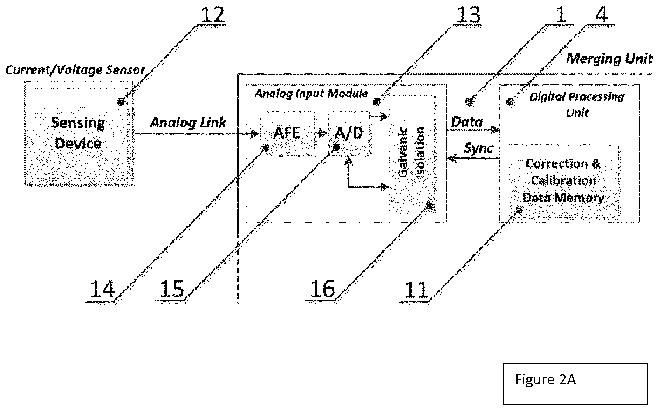

In the first variant, Fig. 2A, the input channel 3 of the merging unit 1 can be equipped with a simple analog input module 13, which modifies only the measured analog data in the input circuits 14 and converts them to the digital form via an analog-to-digital converter 15; the purpose of this module is to process the signals from the sensors connected with short leads. The described configuration is based on the precondition of insignificant ambient disturbances and only a small temperature difference, up to 5°C, between the sensor and the merging unit. The analog-to-digital converters in the input module are synchronized with the internal clock of the merging unit to ensure synchronous acquisition, with very small time jitter of all samples both inside a merging unit and across the entire measuring system connected to the process bus.

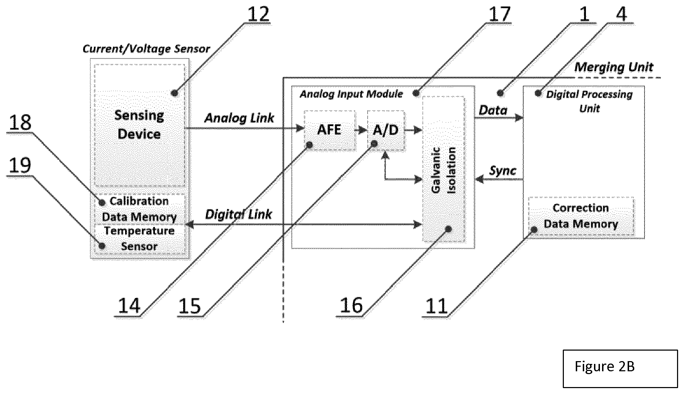

The second variant, Fig. 2B, consists in embedding an input module 17 with analog signal preprocessing 14 and analog-to-digital conversion 15, similarly to the first type; thediscussed second version, however, also contains a digital interface that communicates with an electronic memory 18 and an electronic thermometer 19 placed either directly in the sensor's body or very close to the sensor. This type of connection is suitable for locations where we assume a significant difference between the actual operational conditions, such as temperature, and working conditions of the merging unit; moreover, such connection ensures a higher rate of automation for the procedure of connecting various sensors, during which the merging unit can - based on the configuration - read the correction, that means calibration data from the electronic memory of the sensor and use them to calculate the corrections of the instantaneous values of the measured currents or voltages.

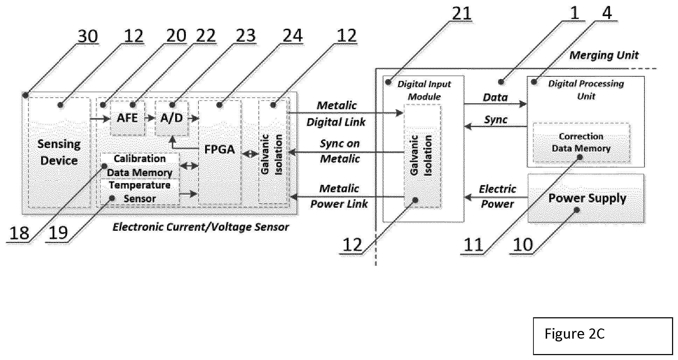

The third input module version, Fig. 2C, is intended for digitized output signal sensors 30, which provide the measured current or voltage directly in a digitized form; these sensors are also equipped with an electronic memory 18 to store specific correction data, and they comprise circuitry 19 for the measurement of the actual operational conditions, including for example temperature, of the sensor. All the data are transmitted to the input module 21 of the merging unit 1 via digital data transfer, where the instantaneous measured values of current or voltage are transferred at the maximum speed given by the applied transmission channel and synchronized with the internal clock 8 of the merging unit 1 via an electrical synchronization signal transferred to the sensor. The speed of transmitting the actual values of the measured spurious effects, such as that of temperature, is defined according to the maximum assumed variability of the considered spurious effect, where, for example in the temperature measurement, the transfer rate of actual values is one sample per second. Such transfer speed is sufficient to provide correct input data for the subsequent calculation of the corrections of temperature characteristics in the applied sensor. The correction data readout from the internal memory 18 of the sensor 2 is activated asynchronously based on a request from the merging unit - for instance, at sensor connection and upon an exceptional request for extra transfer-. The digital data transfer between the sensor 30 and the merging unit 1 is electrically isolated using signal isolators 16; to increase the overall resistance to overvoltage, the isolators are installed on both sides of the transfer path. The described solution exhibits high immunity to ambient disturbance of the transfer path, which is achieved thanks to the digital transfer of the measured signal; furthermore, this version enables automatic reading of the correction data from the attached sensor and facilitates continuous measurement of the sensor's actual operational conditions, which influence the transmission characteristics of the sensing element. Based on these conditions, we can then adjust the measured current or voltage values in the merging unit 1. All the above-described variants, Figs. 2A, 2B, and 2C, connect the sensor via metallic wires transferring the sensor output signals in the analog or digital forms; additionally, a digital synchronization channel is used for precise sampling in sensors with digitized output 30, 31. The sampling of analog values via analog-to-digital converters 23 integrated in the electronic current and voltage sensors 30, 31 or in the input modules 3 of the merging unit is either synchronized or directly clocked by timing circuits of the merging unit 1. The sampling rate is derived from the nominal frequency of the electrical grid for which the given merging unit has been configured, and this speed is set as a fixed multiple, for example 2048x, of the nominal frequency or as a variable in time. In the case of variable sampling rate, it is always ensured that, within a complete message transferred to the process bus, all the data transferred are obtained with the same sampling frequency.

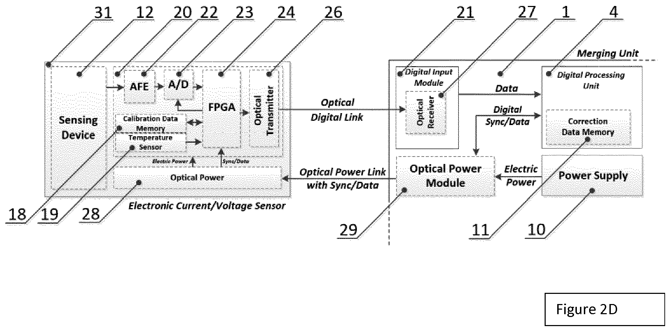

In sensors providing analog output signal in the form of derived primary measured signal, for example in the case of a Rogowski coil used as the current sensing element, the integrated value of the sensor output signal is calculated numerically in the digital section of the merging unit. As regards the connection of a sensor with digitized output signal 30, 31, it is already assumed that the output signal directly corresponds to the instantaneous value of the primary measured quantity, the output signal of the Rogowski coil has been integrated via internal electronic circuits of the sensor. If electrical isolation with an extreme voltage is required, meaning that the voltage is higher than that provided by common miniature electronic transformer of optical isolators, we can utilize non-metallic connection of the sensor in the above-discussed version 3, Fig. 2C; such solution is hereafter described as the input module variant 4, Fig. 2D, in which an optical fiber is used as the transfer medium. This approach can also be applied in long-distance, over 20 m, transmission of signals from the sensors. The connecting interface of the sensor is, in the proposed case, designed as two optical transmission channels having different types of optical connectors due to interchangeability; while one optical transmission channel 27 receives the output digital data from the sensor, the other is used to simultaneously transfer the optical power and the synchronization signal in order to time the sampling in the digitizing section of the sensor. The optical power circuits 28 in the merging unit comprise a power laser diode emitting optical radiation, with the power of at least 200mW, into an optical fiber, which is then connected to a miniature photovoltaic converter on the sensor side; this converter transforms optical radiation energy into electrical one. The applied sensor with digitized output signal and an optical interface 31 must comply with the requirement that no more than 30mW of electrical energy be used to supply the electronics; this precondition can be satisfied by utilizing low power operational amplifiers in the input analog circuits 22, low power analog-to-digital converters 23, and a low power field-programmable gate array 24 to perform digital signal preprocessing. At the subsequent stage, the signals are transmitted via a digital bus using an optical fiber as the transfer medium.

The merging unit 1 is software-parameterizable with respect to the manner and scope of executed corrections and the transfer of sampled values through the process bus. These functions are implemented in the digital section of the merging unit 4, which comprises a powerful field-programmable gate array 5 and a 32-bit microcontroller 6. The main task of the section is to calculate corrections of the instantaneous measured current and voltage values upon knowledge of the correction data to compensate the basic spurious characteristics of the sensors, which include the deviation of the static characteristic and also the temperature, frequency, loading, and positional characteristics. The correction data are uploaded into the electronic memory 11 of the merging unit 1, either manually from a superordinate system during the configuration of the merging unit, via the process bus, or automatically from the attached sensor 2 if this contains an electronic memory 18. While the characteristics typical of a concrete sensor design, such as those obtained during the design tests, are stored in the merging unit 1, the correction or calibration data for a specific sensor, such as those resulting from single tests, are saved directly in the electronic memory 18 of the connected sensor 2. If the sensor does not comprise an electronic memory 18, the specific correction data are stored in the merging unit 1, similarly to the typical characteristics of this type of sensor in a configuration transmitted through the process bus. The correction (calibration) data are saved in the electronic memory 18 of the sensor in the form of individual correction coefficients. The correction data of typical output signal dependencies on the main spurious effects are stored in the merging unit 1 as tables or correction curves, and the calculation of actual correction values applied to the instantaneous measured values of voltage and current exploits the information on operational conditions of the sensor, values of the main spurious effects; the real conditions significantly influence the sensing element's transfer characteristics. The correction data are acquired directly at predefined reference conditions or, alternatively, they are supplemented with information on concrete measurement conditions during a routine or design test. If the correction data are acquired under other than reference conditions, the corrections applied to the measured data are first converted to reference conditions in the merging unit, and this process is performed based on knowledge of the typical characteristic of the sensor to which the given correction data are related. *Reference conditions* denote mainly the amplitude, phase, and frequency of the test current or voltage, the ambient temperature, and the load impedance of the applied postprocessing device. The calculation of corrected instantaneous measured values of voltage or current according to the individual characteristics is performed in the digital section 4 of the merging unit 1; first, corrections of manufacturing and design-related deviations are applied, targeting the static transfer and frequency characteristics of the sensor, and then we can proceed to corrections based on the actual operational conditions, temperature, load, and positional characteristics. The corrected values of the measured voltage or current are subsequently transmitted on the process bus in the form of sampled values. The transmitted messages are received by the electronic protection devices to ensure safe operation of the electrical grid, instruments for energy quality monitoring, or other process bus nodes. The transmission of messages (sampled values) through the process bus is parameterizable with respect to the transmission speed and the number of samples and measurement channels in a transmitted message.

The timing of the digital section of the merging unit is ensured by clock circuitry 8 synchronized via a time synchronization protocol, such as the IEEE 1588, with the time of the superordinate system connected to the process bus. The frequency of the crystal oscillator applied in the clock circuits is thermally stabilized by the structure of the oscillator and further corrected by means of an external voltage signal so that the frequency of the internal clock circuit 8 in the digital section 4 of the merging unit 1 is synchronous with the external clock provided by the superordinate system, the clock source connected to the process bus. If the synchronization cannot be ensured via communication on the process bus, the time synchronization protocol, or if there is no suitable source of clock signal on the bus, we can utilize the direct input of an external synchronization signal, such as 1 PPS - Pulse Per Second, brought from an external source of a precise clock signal.

The described technical solution comprising the above-outlined individual components improves the immunity of the transmission system between the actual sensor and the merging unit against ambient interference, ensures - via correcting the instantaneous measured values of voltage and current - the compensation of spurious effects acting on the sensing element, and includes supplementary information on the sensor characteristics acquired during design and routine tests; generally, the discussed components provide higher accuracy of the measured values, thus forming the basis of the proposed technical solution. The solution is characterized according to the elements listed under independent claim 1. Suitable embodiments of the technical solution are presented within dependent protection claims.

### Brief Description of the Drawings

The technical solution is described in greater detail with respect to its suitable embodiments and considering the annexed drawings.

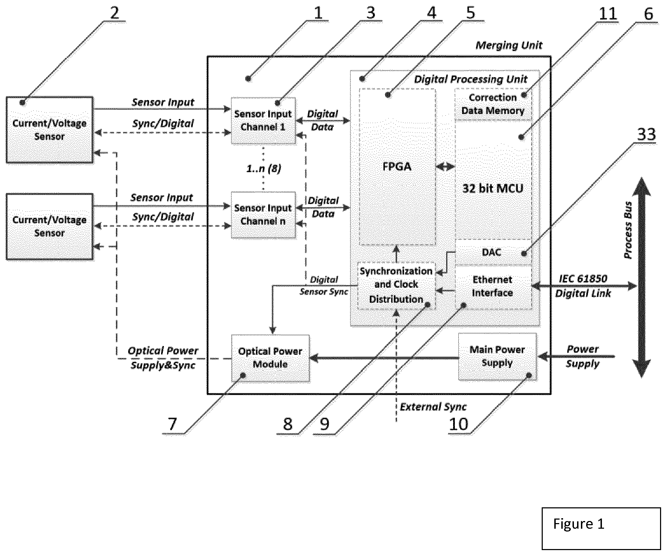

Fig. 1 illustrates the overall concept of voltage and current measurement in high voltage power grids, using sensors without or with an integrated digitizing section and a parameterizable merging unit connected to a process bus.
Figs. 2A-D present variants for connecting the voltage or current sensors to the merging unit; furthermore, the internal structure is shown of a parameterizable merging unit and the corresponding linked sensor (sensing unit), including the representation of the individual functional blocks in these units.

### Embodiments of the Invention

The technical solution of the invention is represented by an exemplary embodiment of a parameterizable merging unit 1 having up to eight configurable inputs 3 for current and voltage sensors 2, where Rogowski coil is typically used as the sensing element for the current sensor, and an impedance voltage divider is applied as the corresponding element for the voltage sensor. In the common configuration and with respect to eventual applicability of the acquired information (for protective purposes), the unit is equipped with four inputs for current sensors and an identical number of inputs for voltage ones. Each input 3 can accommodate either an analog 13, 17 or a digital input module 21, with metallic linking of the sensor. As an option, it is possible to use a digital input module with optical connection of an electronic sensor providing digitized output signal 31. The analog input module 17 comprises a complete analog input section 14 to process the required dynamic and frequency ranges, and it utilizes operational amplifiers manufactured by the Maxim company. Selected amplifiers exhibit an almost zero temperature drift; they modify the amplitude and frequency range of the input voltage signal and ensure overload protection at the module input. The analog input module 17 is ended with a dual, 18-bit analog-to-digital converter with successive approximation 15; the device converts the prepared analog data to the digital form at a fixed sampling frequency derived from the nominal frequency of the electrical grid for which the given merging unit is configured. The sampling rate for a power grid having the nominal frequency of 50 Hz corresponds to 102 400 samples per second, and it is selected with respect to the complexity of the applied anti-aliasing filters contained in the input analog section 14. The synchronization of sampling in analog-to-digital converters 15 with the timing of the entire unit is achieved via an electrical synchronization signal exhibiting an accuracy better than 1 µs. The digital output data from the converters 15 are transferred to the digital postprocessing section 4 of the merging unit 1 through an Analog Devices isolation coupler 16, which also transfers the synchronization signal in the opposite direction. The analog module contains another galvanically isolated data channel if a sensor with an embedded electronic memory 18 and an electronic thermometer 19 is used. This data channel transfers information on the actual operational conditions of the sensor and also the correction coefficients acquired for correction into the digital section of the merging unit during routine tests. The power supply of the analog input module is galvanically isolated via a coupler 16, too. The discussed analog connection is suitable for sensor installation in measuring locations where the cable between the sensor and the merging unit is short and where low ambient interference is assumed. Compared to the digital link discussed hereafter, this solution enables us to install the sensors even in places with the highest assumed range of operating temperatures, eliminating the risk of damage to the electronics located directly in the sensor or in its close vicinity.

If a higher measurement accuracy and minimization of the effect of ambient interference are required, the appropriate input will accommodate a digital input module 21 to receive the digital data frame from a remote digitization unit 20 located inside or in the immediate vicinity of an electronic sensor 30, 31, namely a sensor equipped with additional electronic circuits 22, 23, 24 for the processing of signals and their conversion to the digital form. The digital data frame transmitted by the digitizing unit 20 of the sensor having the sampling frequency of min. 102 400 samples per second for power grids with the nominal frequency of 50 Hz, the applied sampling frequency is identical with the signal sampling frequency in the analog input module, already contains information on the instantaneous value of the measured input quantity; furthermore, in this context, the digital data frame comprises supplementary information on the actual ambient temperature of the sensing element and also calibration data recorded in the electronic memory 18 of the sensor digitizing module 20 during its routine test. In sensors providing the output signal in a time-derived form (the Rogowski coil output signal), the output digital data from the electronic sensor are transmitted already in the integrated form corresponding directly to the instantaneous value of the measured primary current. The received digital data are transmitted over a galvanic isolation coupler 16 to the digital postprocessing section of the unit 4; over this coupler, the synchronization signal for exact timing of the internal analog-to-digital converters 23 in the digitizing circuits of the sensor 20 is also transferred, only in the opposite direction and together with the electrical power supply signal. The digital input module 21 assumes the use of an electronic voltage orcurrent sensor 30 that comprises a digitizing section 20 and transmits the instantaneous values of the measured quantity in the digital form via a transmission protocol compatible with the semi-synchronous serial digital data transmission exhibiting the symbol rate of 4 Mbaud and the data word width of 32 bits. In this case, the interconnection of the electronic sensor with digitized output signal 30 and the merging unit 1 is carried out by means of a metallic electrical line (cable), which utilizes twisted pair cabling and complete cable shielding for additional reduction of the influence of ambient disturbance on the transmitted digital data. Further, the design of the electronic sensor ensures that the current consumption of the electronics integrated in the sensor, and the consumption of the digitizing section 20 in particular, does not exceed the limit of the applied galvanic isolator 16; in the given case, the limit is 250mW.

As an option, the digital input module 21 can be fitted with a transmission system including optical fibers 27 for the reception of measured values from the electronic sensors with digitized output signal 31, where the galvanic isolation of the merging unit and the sensor is ensured by the transmission system itself. If the digital input module 21 with optical connection of the sensor is used, the power supply of the electronics integrated in the sensor utilizes the transmission of energy through the optical fiber from the optical power supply module 7, which also allows the transmission of synchronization signals to the digitizing section 20 of the electronic sensor 31.

The instantaneous values of measured currents and voltages in the digital form are transferred from the input modules 3, 13, 17, 21 to the digital postprocessing section 4 of the merging unit 1, which comprises a field-programmable gate array 5 and a 32-bit microcontroller 6. The field-programmable gate array ensures concentration of the measured values to a single virtual data channel, which is further transmitted to the microcontroller. Depending on the complexity of the corrections, some of these are implemented in the field-programmable gate array 5, others in the microcontroller 6.

The basic design and manufacturing-related deviations, which influence mainly the static transfer characteristics and the amplitude and phase frequency characteristics are compensated based on the correction data acquired during the related routine test; they are entered in the unit manually, using the catalog sheet of the applied sensor, or read automatically through the digital interface directly from the electronic memory 18 of the connected sensor 2 if this sensor is capable of such a task. The coefficients for the correction of the amplitude and phase of the measured signal during real operation of the sensor must be acquired under the reference conditions defined in the merging unit or, alternatively, the correction coefficients must be completed with information on the measurement conditions that characterized the actual acquisition of the correction coefficients, usually during a routine test; this information is subsequently utilized in the conversion of the stored coefficients to modified ones upon knowledge of characteristic dependencies of the sensor output signal on the main spurious effects influencing concrete operational conditions. The characteristic dependencies are acquired during the sensor design tests, in which the main spurious effects influencing the output signal of a sensor are identified and quantified. The reference conditions include the amplitude, phase, frequency of the reference input signal of the electrical voltage or current, load impedance of the applied postprocessing device, and ambient temperature. While the correction coefficient for the amplitude is used for direct multiplication of the instantaneous value of the digitized signal from the sensor, the calculation of the basic phase deviation of the sensor involves only modification of the information on the real time of the sample acquisition in analog-to-digital conversion (positive or negative time shift).

The following stage consists in corrections of the actual operational conditions of the sensor; at this point, the influence of ambient temperature on the sensing element manifests itself most significantly. The temperature corrections are performed using a relevant table from which is selected the appropriate correction coefficient multiplying the actual instantaneous digitized value of the sensor output signal, and they exploit the information on the actual ambient temperature of the sensor obtained from the electronic thermometer 19 located within the sensor body or in its immediate vicinity. Yet another operational correction consists in the compensation of the real magnitude of the input impedance of the merging unit; this magnitude may differ from that of the input impedance value of the postprocessing device used in the routine test. The load impedance influences not only the amplitude but also the phase of the measured signal, and it is therefore necessary to correct again the instantaneous value of the measured signal and to modify also the time of real acquisition of the sample with the time delay corresponding to the phase shift of the signal at nominal frequency of the network.

The selection of manual storage or automatic loading of the correction data into the electronic memory 11 of the merging unit 1 is given by the unit's configuration, which can be adjusted, including the correction data transfer via communication on the process bus. If the internal memory 18 of the connected sensor 2 contains the correction data, then the data are - after the sensor has been attached to the unit or upon request from the superordinate system - automatically transferred to the internal memory in the digital section of the merging unit and subsequently utilized in calculating the corrected instantaneous measured data.

The microcontroller 6 provides synchronization signal for the sampling of the analog-to-digital converters 15 in analog input modules 13, 17, and if electronic sensors with digitized output signal 30, 31 are used, then the microcontroller also ensures external synchronization of the internal converters 23 in these sensors. The transfer of the synchronization signal to the sensors is performed according to the type of the transfer medium of the digital input module 21 and using a metallic or optical cable. Further, according to the IEC 61850 standard, the microcontroller 6 assembles and transmits to the process bus the sampled values from the attached sensors 2, to which corrections of the basic characteristics were applied within the previous steps. The transmission of the sampled values to the process bus is synchronized with the acquisition of the analog input signals from the sensors 2 so that the total delay, from the sampling of the input measured values to their sending onto the process bus, does not exceed 500 µs. Such low digital signal processing delay is facilitated through the use of a powerful field-programmable gate array 5 and a 32-bit microcontroller 6 whose clock frequency is higher than 160 MHz. For successful synchronization of the microcontroller 6 real time clock and to ensure sufficient stability of the frequency of the clock signal source 8 in the merging unit, the applied microcontroller 6 comprises an Ethernet 9 controller with direct support of the time synchronization protocol, which identifies the transfer delay via the process bus from the superordinate system; this system provides a top precision clock signal usually based on the global time standard guaranteed by the satellite positioning system. The local clock signal source 8 uses a compensated crystal oscillator, where the output rectangular signal period is finely adjustable via the analog voltage provided by the internal digital-to-analog converter 33 of the applied microcontroller 6. The Ethernet interface 9, in addition to receiving synchronization messages, transmits to the process bus sampled values of the measured voltage or current, to which all required corrections were already applied in the previous step. The sampled values are arranged into messages, and in an individual message it is possible to parameterize the number of samples transferred from one input channel; in this context and with respect to the capacity of the process bus transfer channel, the sampling rate in the measured values can be parameterized too. The basic rate of 80 samples per nominal frequency period - in 50 Hz signals, the rate corresponds to 4000 samples per second- can be progressively increased up to the maximum available rate, which is, with respect to the speed of the basic digital data sampling in input modules or sensors, reduced to max. 102 400 samples per second, namely 2048 samples per period of the 50 Hz basic signal. For signals with a basic frequency other than 50 Hz, the sampling frequency can be derived from a different basic frequency, such as the 60 Hz one. At this speed, a process bus with thetransfer rate of 100 Mbit/s already operates at its maximum working load and cannot transfer messages from the other connected units; thus, the discussed maximum transfer speed is applicable exclusively in special cases, for example when the merging unit only monitors the quality of electrical energy and is directly linked with the superordinate postprocessing system.

For the purposes of communicating with sensors connected to it via an optical interface, the merging unit contains an optical power module 7, which provides the optical radiation energy of min. 200 mW in the invisible spectrum; this energy is radiated by a power laser diode into the optical fiber to supply an electronic sensor with optical fiber output 26. If optical feeding is required for complete set of eight sensors, then the optical power module 7 will accommodate a laser diode radiating the power of min. 2W into the optical fiber; this power is subsequently divided among 8 outputs by means of an optical splitter. The transfer channel facilitating the optical power supply also provides synchronization signal for timing the internal analog-to-digital converters in the sensors. The pulse width of this synchronization signal does not exceed 1/10 of its period in order to minimize the decrease of the power transferred to supply the connected sensors with optical radiation energy.

## Claims

1. A parameterizable merging unit (1) for sensor-based measurement of current and voltage in high voltage networks or electrical grids operating with different voltage levels, comprising:
- a plurality of inputs (3) configured to receive a signal from a plurality of sensors comprising a current sensor (2) and a voltage sensor (2);
- a memory (11) configured to store correction data comprising a correction table;
wherein the signal from each of the current sensor and the voltage sensor comprises instantaneous measured values of current or voltage and an ambient temperature of the current sensing element or voltage sensing element;
wherein the merging unit is configured to correct the instantaneous measured values of current or voltage, wherein the merging unit is configured to apply a temperature correction by multiplying the instantaneous measured values of current or voltage by a correction coefficient selected from the correction table, and wherein the merging unit is configured to apply a time delay to the instantaneous measured values of current or voltage corresponding to a phase shift of the instantaneous measured values at a nominal frequency of the voltage network or electrical grid.

2. Parameterizable merging unit, according to claim 1,
wherein the merging unit comprises analog and/or digital input modules to connect current and/or voltage sensors providing a native analog and/or a digitized signal.

3. Parameterizable merging unit, according to claim 2,
wherein the digital input module can receive input digital data via metallic or optical link.

4. Parameterizable merging unit, according to claim 1,
wherein the merging unit comprises a digital postprocessing section consisting of a field-programmable gate array and a microcontroller.

5. Parameterizable merging unit, according to claim 4,
wherein the microcontroller assembles the transfer protocol for the digital process bus.

6. Parameterizable merging unit, according to claim 4,
wherein the microcontroller synchronizes its time and the sampling of measured values with the superordinate system via a time synchronization protocol.

7. Parameterizable merging units, according to claim 1,
wherein the merging unit comprises a module to power the electronic sensors having digitized output signal with optical radiation energy transported through an optical fiber.

8. Parameterizable merging unit, according to claim 1,
wherein a time integral of the output signal from the current sensor is calculated digitally in the field-programmable gate array and/or by the microcontroller.

9. Parameterizable merging unit, according to claim 1,
wherein a sampling frequency of analog-to-digital converters in the electronic sensors having digitized output signal and/or in the input modules of the merging unit is either time-variable or fixed to the nominal frequency of the voltage network or electrical grid.

10. Parameterizable merging unit, according to claim 1,
wherein the merging unit facilitates parameterization of the transfer rate of sampled values and/or the number of samples transferred in a single message to the output digital bus.

11. Method for operating a parameterizable merging unit according to any of claims 1-10, comprising:
receiving by a plurality of inputs (3) of the merging unit a signal from a plurality of sensors comprising a current sensor (2) and a voltage sensor (2), and wherein the signal from each of the current sensor and the voltage sensor comprises instantaneous measured values of current or voltage and an ambient temperature of the current sensing element or voltage sensing element;
correcting by the merging unit the instantaneous measured values of current or voltage, comprising:
applying a temperature correction by multiplying the instantaneous measured values of current or voltage by a correction coefficient selected from a correction table stored in a memory (11) of the merging unit;
applying a time delay to the instantaneous measured values of current or voltage, wherein the time delay corresponds to a phase shift of the instantaneous measured values at a nominal frequency of the voltage network or electrical grid to correct for the input impedance of the merging unit.

## Patentansprüche

1. Parametrierbare Zusammenführungseinheit (1) zur sensorbasierten Messung von Strom und Spannung in Hochspannungsnetzwerken oder elektrischen Netzen, die mit unterschiedlichen Spannungspegeln arbeiten, umfassend:
- eine Mehrzahl von Eingängen (3), die dazu ausgelegt sind, ein Signal von einer Mehrzahl von Sensoren zu empfangen, die folgendes umfassen
einen Stromsensor (2) und einen Spannungssensor (2);
- einen Speicher (11), der dazu ausgelegt ist, Korrekturdaten zu speichern, die eine Korrekturtabelle umfassen;
wobei das Signal sowohl des Stromsensors als auch des Spannungssensors momentane Messwerte des Stroms oder der Spannung und eine Umgebungstemperatur des Stromsensorelements oder des Spannungssensorelements umfasst;
wobei die Zusammenführungseinheit dazu ausgelegt ist, die momentanen Messwerte des Stroms oder der Spannung zu korrigieren, wobei die Zusammenführungseinheit dazu ausgelegt ist, eine Temperaturkorrektur durch Multiplizieren der momentanen Messwerte des Stroms oder der Spannung mit einem aus der Korrekturtabelle ausgewählten Korrekturkoeffizienten anzuwenden, und wobei die Zusammenführungseinheit dazu ausgelegt ist, eine Zeitverzögerung auf die momentanen Messwerte des Stroms oder der Spannung anzuwenden, die einer Phasenverschiebung der momentanen Messwerte bei einer Nennfrequenz des Spannungsnetzwerks oder des elektrischen Netzes entspricht.

2. Parametrierbare Zusammenführungseinheit nach Anspruch 1,
wobei die Zusammenführungseinheit analoge und/oder digitale Eingangsmodule umfasst, um Strom- und/oder Spannungssensoren anzuschließen, die ein natives analoges und/oder ein digitalisiertes Signal bereitstellen.

3. Parametrierbare Zusammenführungseinheit nach Anspruch 2,
wobei das digitale Eingangsmodul digitale Eingangsdaten über einen metallischen oder optischen Link empfangen kann.

4. Parametrierbare Zusammenführungseinheit nach Anspruch 1,
wobei die Zusammenführungseinheit einen digitalen Nachbearbeitungsabschnitt umfasst, der aus einem feldprogrammierbaren Gate-Array und einem Mikrocontroller besteht.

5. Parametrierbare Zusammenführungseinheit nach Anspruch 4,
wobei der Mikrocontroller das Übertragungsprotokoll für den digitalen Prozessbus zusammenstellt.

6. Parametrierbare Zusammenführungseinheit nach Anspruch 4,
wobei der Mikrocontroller seine Zeit und das Abtasten von Messwerten über ein Zeitsynchronisationsprotokoll mit dem übergeordneten System synchronisiert.

7. Parametrierbare Zusammenführungseinheiten nach Anspruch 1,
wobei die Zusammenführungseinheit ein Modul umfasst, um die elektronischen Sensoren mit digitalisiertem Ausgangssignal mit optischer Strahlungsenergie zu versorgen, die durch eine optische Faser transportiert wird.

8. Parametrierbare Zusammenführungseinheit nach Anspruch 1,
wobei ein Zeitintegral des Ausgangssignals von dem Stromsensor in dem feldprogrammierbaren Gate-Array und/oder von dem Mikrocontroller digital berechnet wird.

9. Parametrierbare Zusammenführungseinheit nach Anspruch 1,
wobei eine Abtastfrequenz von Analog-Digital-Umsetzern in den elektronischen Sensoren mit digitalisiertem Ausgangssignal und/oder in den Eingangsmodulen der Zusammenführungseinheit entweder zeitvariabel oder auf die Nennfrequenz des Spannungsnetzwerks oder elektrischen Netzes festgelegt ist.

10. Parametrierbare Zusammenführungseinheit nach Anspruch 1,
wobei die Zusammenführungseinheit eine Parametrisierung der Übertragungsrate von Abtastwerten und/oder der Anzahl der in einer einzigen Nachricht an den digitalen Ausgangsbus übertragenen Abtastwerte ermöglicht.

11. Verfahren zum Betreiben einer parametrierbaren Zusammenführungseinheit nach einem der Ansprüche 1-10, umfassend:
Empfangen eines Signals von einer Mehrzahl von Sensoren, umfassend einen Stromsensor (2) und einen Spannungssensor (2), durch eine Mehrzahl von Eingängen (3) der Zusammenführungseinheit, und wobei das Signal von jedem des Stromsensors und des Spannungssensors momentane Messwerte des Stroms oder der Spannung und eine Umgebungstemperatur des Stromsensorelements oder des Spannungssensorelements umfasst;
das Korrigieren der momentanen Strom- oder Spannungsmesswerte durch die Zusammenführungseinheit, umfassend:
Anwenden einer Temperaturkorrektur durch Multiplizieren der momentanen Messwerte von Strom oder Spannung mit einem Korrekturkoeffizienten, der aus einer in einem Speicher (11) der Zusammenführungseinheit gespeicherten Korrekturtabelle ausgewählt wird;
Anwenden einer Zeitverzögerung auf die momentanen Messwerte von Strom oder Spannung, wobei die Zeitverzögerung einer Phasenverschiebung der momentanen Messwerte bei einer Nennfrequenz des Spannungsnetzwerks oder elektrischen Netzes entspricht, um die Eingangsimpedanz der Zusammenführungseinheit zu korrigieren.

## Revendications

1. Unité de fusion paramétrable (1) pour la mesure basée sur capteurs d'un courant et d'une tension dans des réseaux haute tension ou des réseaux électriques fonctionnant avec des niveaux de tension différents, comprenant :
- une pluralité d'entrées (3) configurées pour recevoir un signal en provenance d'une pluralité de capteurs comprenant un capteur de courant (2) et un capteur de tension (2) ;
- une mémoire (11) configurée pour stocker des données de correction comprenant une table de correction ;
dans laquelle le signal en provenance de chaque capteur parmi le capteur de courant et le capteur de tension comprend des valeurs mesurées instantanées de courant ou de tension et une température ambiante de l'élément de détection de courant ou de l'élément de détection de tension ;
dans laquelle l'unité de fusion est configurée pour corriger les valeurs mesurées instantanées de courant ou de tension, dans laquelle l'unité de fusion est configurée pour appliquer une correction de température en multipliant les valeurs mesurées instantanées de courant ou de tension par un coefficient de correction sélectionné à partir de la table de correction, et dans laquelle l'unité de fusion est configurée pour appliquer un retard temporel aux valeurs mesurées instantanées de courant ou de tension correspondant à un déphasage des valeurs mesurées instantanées à une fréquence nominale du réseau de tension ou du réseau électrique.

2. Unité de fusion paramétrable selon la revendication 1,
dans laquelle l'unité de fusion comprend des modules d'entrée analogique et/ou numérique pour connecter des capteurs de courant et/ou de tension fournissant un signal analogique natif et/ou un signal numérisé.

3. Unité de fusion paramétrable selon la revendication 2,
dans laquelle le module d'entrée numérique peut recevoir des données numériques d'entrée via une liaison métallique ou optique.

4. Unité de fusion paramétrable selon la revendication 1,
dans laquelle l'unité de fusion comprend une section de post-traitement numérique qui est constituée par un réseau pré-diffusé programmable et un microcontrôleur.

5. Unité de fusion paramétrable selon la revendication 4,
dans laquelle le microcontrôleur assemble le protocole de transfert pour le bus de traitement numérique.

6. Unité de fusion paramétrable selon la revendication 4,
dans laquelle le microcontrôleur synchronise son temps et l'échantillonnage de valeurs mesurées avec le système de niveau supérieur via un protocole de synchronisation de temps.

7. Unité de fusion paramétrable selon la revendication 1,
dans laquelle l'unité de fusion comprend un module pour alimenter les capteurs électroniques présentant un signal de sortie numérisé avec de l'énergie de rayonnement optique transportée au travers d'une fibre optique.

8. Unité de fusion paramétrable selon la revendication 1,
dans laquelle une intégrale sur le temps du signal de sortie en provenance du capteur de courant est calculée numériquement dans le réseau pré-diffusé programmable et/ou par le microcontrôleur.

9. Unité de fusion paramétrable selon la revendication 1,
dans laquelle une fréquence d'échantillonnage de convertisseurs analogique à numérique dans les capteurs électroniques présentant un signal de sortie numérisé et/ou dans les modules d'entrée de l'unité de fusion soit varie en fonction du temps, soit est fixée par rapport à la fréquence nominale du réseau de tension ou du réseau électrique.

10. Unité de fusion paramétrable selon la revendication 1,
dans laquelle l'unité de fusion facilite la paramétrisation du débit de transfert de valeurs échantillonnées et/ou du nombre d'échantillons transférés dans un unique message sur le bus numérique de sortie.

11. Procédé de fonctionnement d'une unité de fusion paramétrable selon l'une quelconque des revendications 1 à 10, comprenant :
la réception, par une pluralité d'entrées (3) de l'unité de fusion, d'un signal en provenance d'une pluralité de capteurs comprenant un capteur de courant (2) et un capteur de tension (2), et dans lequel le signal en provenance de chaque capteur parmi le capteur de courant et le capteur de tension comprend des valeurs mesurées instantanées de courant ou de tension et une température ambiante de l'élément de détection de courant ou de l'élément de détection de tension ;
la correction, par l'unité de fusion, des valeurs mesurées instantanées de courant ou de tension, comprenant :
l'application d'une correction de température en multipliant les valeurs mesurées instantanées de courant ou de tension par un coefficient de correction sélectionné à partir d'une table de correction stockée dans une mémoire (11) de l'unité de fusion ; et
l'application d'un retard temporel aux valeurs mesurées instantanées de courant ou de tension, dans lequel le retard temporel correspond à un déphasage des valeurs mesurées instantanées à une fréquence nominale du réseau de tension ou du réseau électrique pour corriger l'impédance d'entrée de l'unité de fusion.
